# EUROPÄISCHE PATENTSCHRIFT

(11) **EP 0 564 934 B1**
(45) Veröffentlichungstag und Bekanntmachung des Hinweises auf die Patenterteilung: **19.05.1999**
(21) Anmeldenummer: 93105088.4
(22) Anmeldetag: 27.03.1993
(51) Int. Cl.: H03H 11/04, H04N 9/78

(54) **Durchlassfilter für ein trägerfrequentes Signal**
Band press filter for a carrier frequency signal
Filtre passe-bande pour un signal à onde porteuse

(30) Priorität: 06.04.1992 DE 4211483
(43) Veröffentlichungstag der Anmeldung: 13.10.1993
(73) Patentinhaber: DEUTSCHE THOMSON-BRANDT GMBH, 78048 Villingen-Schwenningen (DE)
(72) Erfinder: Koblitz, Rudolf, F-38240 Meylan (FR); Debaty, Pascal, F-38420 Domene (FR)

(56) Entgegenhaltungen:
- US-A- 3 895 323
- PATENT ABSTRACTS OF JAPAN vol. 10 no. 91 (E-394) ,9.April 1986 & JP-A-60 233993 (ROOMU) 20.November 1985,
- IEEE TRANS ON USER ELECTRONICS , Bd. 35,Nr. 4, November 1989 NEW YORK, Seiten 741-747, XP 000087092 M. KAWANO ET AL 'A SINGLE CHIP Y/C SIGNAL PROCESSING IC FOR VHS VCRS'

## Beschreibung

Die Erfindung geht aus von einem Filter gemäß dem Oberbegriff des Anspruchs 1. Das Filter ist insbesondere anwendbar für den modulierten SECAM-Farbträger in einem Farbfrequenzempfänger.

In einem Farbfernsehempfänger muß das FBAS- oder VCBS-Signal frequenzselektiv in das Leuchtdichtesignal Y und das Chromasignal C aufgespalten werden. Für das Chromasignal ist daher ein Filter erforderlich, das bei einem SECAM-Farbträger auch als Bell-Filter bezeichnet wird. Dieses Filter muß eine relativ hohe Güte von Q=16 und eine Genauigkeit in der Durchlaßfrequenz von 4,286 MHz ±10 kHz haben und ist daher schwer realisierbar. Es ist daher vorteilhaft, ein derartiges Filter wegen der hohen Anforderungen und der temperaturbedingten Abweichungen als selbstabgleichendes Filter auszubilden. Es ist bekannt, einen konventionellen LC-Schwingkreisvorzusehen, der auf eine ca 5 % zu hohe Mittenfrequenz abgestimmt ist und durch im IC angeordnete, binär gestufte Kapazitäten während des Vertikalrücklaufs auf die richtige Frequenz abgestimmt wird. Hierzu wird während des Vertikalrücklaufes der LC-Schwingkreis als frequenzbestimmendes Glied in einen Oszillator eingeschaltet, der dann auf der Mittenfrequenz des Bell-Filters schwingt. Eine Logik vergleicht die Schwingfrequenz des LC-Oszillators mit der Mittenfrequenz des Farbdemodulators, die bei 4,25 MHz liegt. Diese Frequenz liegt um 36 kHz zu tief. Das binär gestufte Kapazitätsnetzwerk wird solange verstimmt, und zwar bei jedem Vertikalrücklauf um eine Stufe, bis die Frequenz eine ausreichende Übereinstimmung mit der Sollfrequenz aufweist. Diese Lösung hat den Nachteil, daß wegen der abgestuften Kapazitäten und der Diskretisierung keine genaue Abstimmung auf die Sollfrequenz möglich ist. Damit ist die Lösung sehr aufwendig, weil die Schaltung in einer 2µ-Technologie einen Platz von ca 2 mm² erfordert.

Der Erfindung liegt die Aufgabe zugrunde, eine selbstabstimmende Schaltung mit kontinuierlicher Abstimmung ohne Diskretisierung zu schaffen, die für ein IC besonders geeignet ist und für die Abstimmung nur einen nicht veränderbaren Kondensator benötigt. Diese Aufgabe wird durch die im Anspruch 1 angegebene Erfindung gelöst. Vorteilhafte Weiterbildungen der Erfindung sind in den Unteransprüchen angegeben.

Bei der Erfindung werden also weder eine Kapazitätsdiode noch eine Vielzahl von stufenweise einschaltbaren Kondensatoren verwendet.,Vielmehr ist für die Abstimmung des Schwingkreises nur ein kleiner Kondensator vorgesehen, dessen eine Elektrode an den Schwingkreis angeschlossen ist. Die Wirkung des Kondensators auf den Schwingkreis zum Zwecke der Abstimmung wird dadurch geändert, daß die an der ersten Elektrode stehende Wechselspannung mit einem veränderbaren Übertragungsmaß auf die zweite Elektrode des Kondensators übertragen wird. Das Übertragungsmaß ist dabei durch eine Stellgröße gesteuert, die durch Vergleich der jeweiligen Resonanzfrequenz des Schwingkreises mit der Soll-Durchlaufrequenz des Schwingkreises gewonnen ist. Durch diese Einkopplung der Wechselspannung auf die zweite Elektrode des Kondensators kann somit die Wirksamkeit des Kondensators auf den Schwingkreis verändert werden. Es wird somit ein elektronisch veränderbarer Kondensator gebildet. Ein wesentlicher Vorteil besteht darin, daß nunmehr eine kontinuierliche analoge Abstimmung ohne Diskretisierung möglich ist und somit die gewünschte Durchlaßfrequenz des Filters sehr genau eingeregelt werden kann. Trotzdem wird nur ein kleiner Kondensator benötigt, der nicht veränderbar zu sein braucht. Durch eine Änderung des Übertragungsmaßes der Spannung von der ersten Elektrode zu der zweiten Elektrode des Kondensators zwischen 0 und 2 läßt sich eine Polaritätsumkehr des Stromes in dem Kondensator erzielen. Das bedeutet, daß der Kondensator eine negative Kapazität, d.h. für den Schwingkreis eine Induktivität darstellt. Dadurch, daß der wirksame Wert des Kondensators um null herum geändert werden kann, also kapazitiv und induktiv werden kann, kann der Schwingkreis selbst genau auf die Sollfrequenz abgestimmt sein. Der Kondensator bewirkt dann nur eine Korrektur der Mittenfrequenz des Schwingkreises, jedoch keine grundsätzliche Verstimmung des Schwingkreises. Durch diese Lösung ist die Gesamtschaltung besonders unempfindlich gegen Phasendrehungen.

Die Erfindung wird im folgenden anhand der Zeichnung an einem Ausführungsbeispiel erläutert. Darin zeigen
- Fig. 1: ein Prinzipschaltbild der erfindungsgemäßen Lösung,
- Fig. 2: eine Tabelle zur Erläuterung der Wirkungsweise der Fig. 1,
- Fig. 3: ein erweitertes Schaltbild zu Fig. 1 und
- Fig. 4: eine praktisch erprobte Schaltung für einen integrierten Schaltkreis.

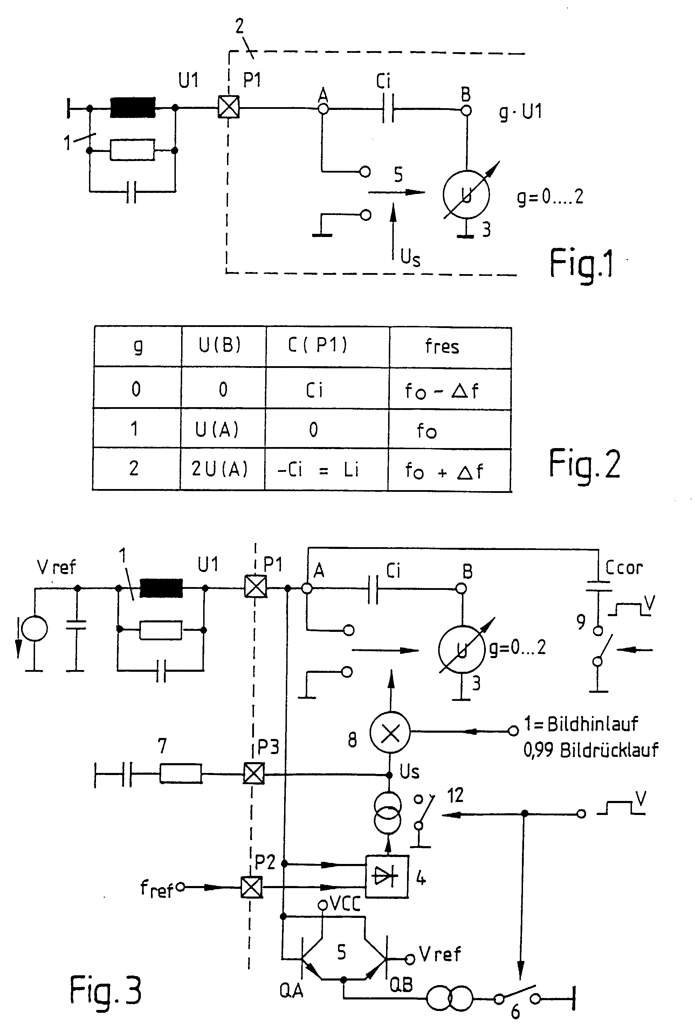

Fig. 1 zeigt den Schwingkreis 1, der Bestandteil eines Bell-Filters für den SECAM-Farbträger ist. Der Schwingkreis 1 ist an den Pin P1 des integrierten Schaltkreises 2 angeschlossen. P1 ist mit der ersten Elektrode A des internen Abstimmkondensators Ci verbunden. Die zweite Elektrode B von Ci ist an die Spannungsquelle 3 angeschlossen. Eine Stellgröße Us, die die Abweichung der Resonanzfrequenz des Schwingkreises 1 von der Sollfrequenz fref darstellt, steuert das Übertragungsmaß g, mit dem die Spannung U1 an der Elektrode A auf die Elektrode B des Kondensators Ci übertragen wird. Dieses ist symbolisch durch den Pfeil 5 und die steuerbare Spannungsquelle 3 dargestellt. Die Spannungsquelle 3 erzeugt an der Elektrode B eine Spannung mit der gleichen Frequenz und der gleichen Phase wie die Spannung an der Elektrode A, jedoch mit einer durch Us veränderbaren Amplitude.

Anhand der Fig. 2 wird die Wirkungsweise erläutert. Wenn das Übertragungsmaß g = 0 ist ist die Spannung U(B) an der Elektrode B null, die Elektrode B also geerdet. Das bedeutet, daß der Kondensator Ci mit seiner vollen Kapazität C (P1) am Schwingkreis 1 wirksam ist und somit dessen Resonanzfrequenz fref auf den Minimalwert fo-Δ f verringert wird. Wenn das Übertragungsmaß g=1 ist, ist die Spannung U(B) gleich U(A). An den beiden Elektroden A und B steht also eine in Frequenz, Phase und Amplitude gleiche Spannung. Das bedeutet, daß die wirksame Kapazität C(P1) von Ci gleich null ist. Der Schwingkreis 1 hat dann seine Mittenfrequenz fo und wird durch Ci gar nicht verstimmt. Wenn g=2 ist, also die Spannung U(B) an der Elektrode B den doppelten Wert der Spannung an der Elektrode A hat, ist nach wie vor U(B) in Phase mit U(A), jedoch doppelt so groß. Gegenüber dem Fall g=0 ist dadurch der Strom durch Ci um 180° gedreht. Das bedeutet, daß sich Ci wie eine Induktivität, nämlich wie eine negative Kapazität verhält. Dem Schwingkreis 1 ist jetzt eine Induktivität parallel geschaltet, wodurch die gesamt wirksame Induktivität des Schwingkreises 1 verringert und die Resonanzfrequenz auf den Wert fo + Δf erhöht wird. Es ist ersichtlich, daß durch diese Schaltung die Resonanzfrequenz des Schwingkreises 1 um den Sollwert fo herum durch Zuschalten einer veränderbaren Kapazität oder einer veränderbaren Induktivität geändert werden kann.

Fig. 3 zeigt eine ergänzte Form der Prinzipschaltung von Fig. 1. Der Schwingkreis 1 ist als frequenzbestimmendes Glied in den durch QA und QB gebildeten Oszillator 5 eingeschaltet, der von dem Vertikalrücklaufimpuls V über den Schalter 6 nur während der Vertikalrücklaufzeit aktiv geschaltet ist. Der Oszillator 5 erzeugt somit während der Vertikalrücklaufzeit eine Spannung, deren Frequenz von der Resonanzfrequenz des Schwingkreises 1 abhängig ist. Diese Spannung gelangt zusammen mit der Spannung mit der Referenzfrequenz fref auf die Phasenvergleichsstufe 4, die an dem an Pin P3 angeschlossenen Siebglied 7 die während der Vertikalhinlaufzeit aufrechterhaltende geglättete Stellgröße Us erzeugt. Diese Stellgröße wird noch durch die steuerbare Verstärkerstufe 8 in der Verstärkung zwischen dem Wert 1 bei Bildhinlauf und dem Wert 0,99 bei Bildrücklauf umgeschaltet und wie in Fig. 1 zur Steuerung des Übertragungsmaßes g ausgenutzt. Während der Vertikalrücklaufzeit wird durch den Impuls V außerdem der Korrekturkondensator Ccor über den Schalter 9 dem Schwingkreis parallel geschaltet. Die Wirkung von Ccor ist identisch mit der Umschaltung der Verstärkung in der Stufe 8. Diese beiden Möglichkeiten für die Umschaltung zwischen Bildhinlauf und Bildrücklauf können alternativ oder auch additiv angewendet werden. Durch den Schalter 12, der ebenfalls von dem Vertikalrücklaufimpuls V geschlossen wird, ist angedeutet, daß die Phasenvergleichsstufe 4 auch nur während der Zeit aktiv geschaltet ist, während der auch der den Schwingkreis 1 beinhaltende Oszillator 5 durch den Impuls V aktiv geschaltet ist.

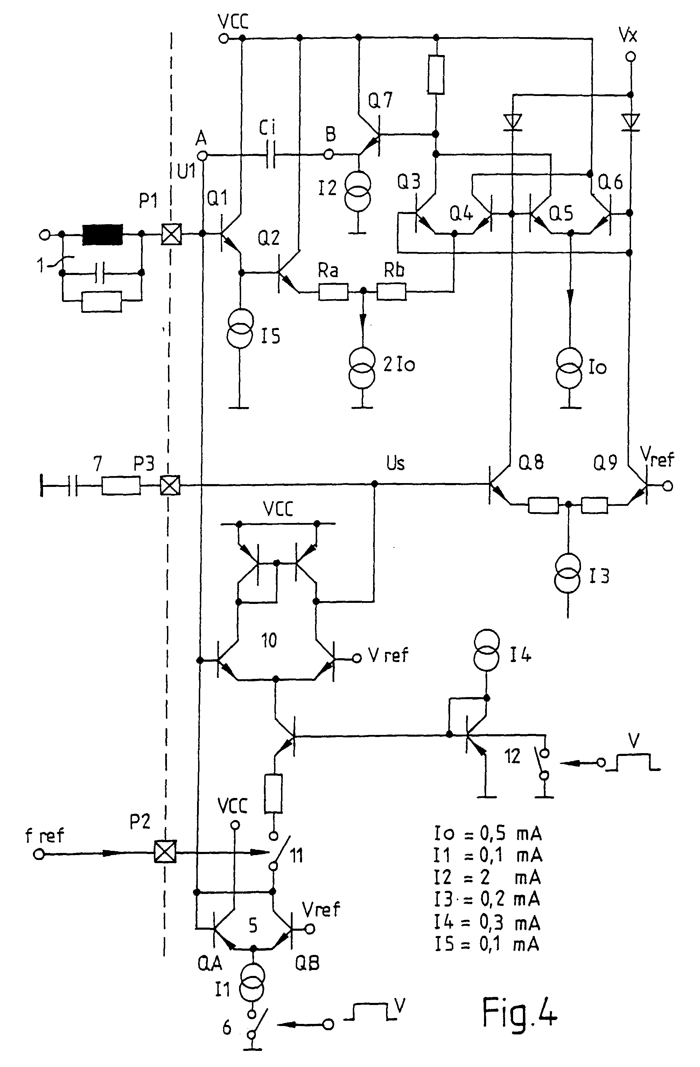

Fig. 4 zeigt eine praktisch erprobte Schaltung nach Fig. 3. Die Spannung U1 an der Elektrode A gelangt über die als Emitterfolger arbeitenden Transistoren Q1 und Q2 auf den Differenzverstärker mit den Transistoren Q3 und Q4 und über den als Emitterfolger arbeitenden Transistor Q7 auf die Elektrode B. Die als Phasenvergleichsstufe arbeitende Schaltung 10 liefert die Stellgröße Us, die zusammen mit einer Vergleichsspannung Vref dem Differenzverstärker mit den Transistoren Q8 und Q9 zugeführt wird. Die Ausgänge des Differenzverstärkers Q8, Q9 gelangen auf die Eingänge des Differenzverstärkers Q3, Q4 und ebenso auf die Eingänge des Differenzverstärker Q5, Q6. Wie in Fig. 1 und 3 steuert die Stellgröße Us das Übertragungsmaß g der Spannung U1 von der Elektrode A zu der Elektrode B zwischen den Werten g=0 und g=2. Der Oszillator 5 ist wieder durch die Transistoren QA und QB realisiert. In Fig. 4 erfolgt ein spezieller Phasenvergleich entsprechend der Phasenvergleichsstufe 4 in Fig. 3. Der Multiplikator wird durch die Transistoren QA und QB gebildet. Der durch die Referenzspannung fref betätigte Schalter 11 stellt dabei einen Eingang des Phasenvergleiches zwischen der Spannung U1 vom Schwingkreis 1 und der Referenzspannung fref dar. Der durch den Vertikalrücklaufimpuls V geöffnete Schalter 12 deutet an, daß der Phasenvergleich wiederum nur während der Vertikalrücklaufzeit erfolgt.

## Patentansprüche

1. Durchlaßfilter für ein trägerfrequentes Signal mit einem Parallelschwingkreis (1), dem eine durch eine die Abweichung der Resonanzfrequenz vom Sollwert darstellende Stellgröße (Us) gesteuerte Kapazität (Ci) hinzugeschaltet ist, **dadurch gekennzeichnet,**
daß ein Abstimmkondensator (Ci) vorgesehen ist, dessen erste Elektrode (A) an den Schwingkreis (1) und dessen zweite Elektrode (B) an eine durch die Stellgröße (Us) gesteuerte Spannungsquelle (3) mit der am Schwingkreis (1) stehenden Spannung (U1) angeschlossen ist, wodurch die am Schwingkreis (1) stehende Spannung (U1) mit einem durch die Stellgröße (Us) gesteuerten Übertragungsmaß (g) auf die zweite Elektrode (B) übertragen wird.

2. Filter nach Anspruch 1, **dadurch gekennzeichnet,** daß das Übertragungsmaß (g) zwischen 0 und 2 veränderbar ist.

3. Filter nach Anspruch 1, **dadurch gekennzeichnet,** daß das Filter (1) in wiederkehrenden Zeitabschnitten als frequenzbestimmendes Glied in einen Oszillator (5) eingeschaltet und dessen Ausgangsspannung zusammen mit einer Referenzfrequenzspannung (fref) an die Eingänge einer die Stellgröße (Us) liefernden Phasenvergleichsstufe (4) angelegt ist.

4. Filter nach Anspruch 3, **dadurch gekennzeichnet,** daß der Zeitabschnitt der Vertikalrücklaufzeit oder einem Teil der Vertikalrücklaufzeit entspricht.

5. Filter nach Anspruch 1, **dadurch gekennzeichnet,** daß zwischen der ersten Elektrode (A) und der zweiten Elektrode (B) des Abstimmkondensators (Ci) eine durch die Stellgröße (Us) gesteuerte Verstärkerstufe (Q1 - Q7) liegt.

6. Filter nach Anspruch 5, **dadurch gekennzeichnet,** daß die Stellgröße (Us) und eine Referenzspannung (Vref) an die Eingänge eines ersten Differenzverstärkers (Q8, Q9) angelegt sind, dessen Ausgänge das Übertragungsmaß der Spannung (U1) von der ersten Elektrode (A) zur zweiten Elektrode (B) des Abstimmkondensators (Ci) steuern

7. Filter nach Anspruch 6, **dadurch gekennzeichnet,** daß die Ausgänge des ersten Differenzverstärkers (Q8, Q9) an die Basen der beiden Transistoren (Q3, Q4) eines zweiten Differenzverstärkers und ebenso an die Basen der beiden Transistoren (Q5, q6) eines dritten Differenzverstärkers angeschlossen sind, daß die erste Elektrode des Abstimmkondensators (Ci) über eine Verstärkerstufe (Q1, Q2) an die miteinander verbundenen Emitter der Transistoren (Q3, Q4) des zweiten Differenzverstärkers angeschlossen ist, daß die Kollektoren jeweils von zwei Transistoren (Q3, Q5 bzw. Q4, Q6) des zweiten und dritten Differenzverstärkers miteinander verbunden und ein Verbindungspunkt an die Betriebsspannung (VCC) und der andere Verbindungspunkt an den Eingang einer Verstärkerstufe (Q7) und dessen Ausgang an die zweite Elektrode (B) des Abstimmkondensators (Ci) angeschlossen ist (Fig. 4).

8. Filter nach Anspruch 7, **dadurch gekennzeichnet,** daß die Verstärkerstufen (Q1, Q2, Q7) als Emitterfolger ausgebildet sind.

9. Filter nach Anspruch 3, **dadurch gekennzeichnet,** daß zwischen der Mittenfrequenz des Schwingkreises (1) und der Referenzfrequenz (fref) eine Differenz besteht.

10. Filter nach Anspruch 3, **dadurch gekennzeichnet,** daß im Weg der Stellgröße Us eine steuerbare Verstärkerstufe (8) liegt, deren Verstärkung durch einen Vertikalrücklaufimpuls (V) zwischen Bildhinlauf und Bildrücklauf auf verschiedene Verstärkungsfaktoren (1 bzw 0,99) umgeschaltet ist.

## Claims

1. Pass-band filter for a carrier frequency signal including a parallel resonant circuit (1) into which there is connected a capacity (Ci) that is controlled by a control variable (Us) representing the deviation of the resonant frequency from the reference value, characterised in that, there is provided a tuning capacitor (Ci) whose first electrode (A) is connected to the resonant circuit (1) and whose second electrode (B) is connected to a voltage source (3) which is controlled by the control variable (Us) with the voltage (U1) occurring on the resonant circuit (1) whereby the voltage (U1) occurring on the resonant circuit (1) is conveyed to the second electrode (B) using a transmission factor (g) that is controlled by the control variable (Us).

2. Filter in accordance with claim 1, characterised in that, the transmission factor (g) can be altered between 0 and 2.

3. Filter in accordance with claim 1, characterised in that, the filter (1) is connected into circuit as the frequency determining member of an oscillator (5) in recurring time slots and its output voltage is applied together with a reference frequency voltage (fref) to the inputs of a phase comparison stage (4) which delivers the control variable (Us).

4. Filter in accordance with claim 3, characterised in that, the time slot corresponds to the vertical flyback period or a portion of the flyback period.

5. Filter in accordance with claim 1, characterised in that, an amplifying stage (Q1 - Q7) that is controlled by the control variable (Us) is located between the first electrode (A) and the second electrode (B) of the tuning capacitor (Ci).

6. Filter in accordance with claim 5, characterised in that, the control variable (Us) and a reference voltage (Vref) are applied to the inputs of a first differential amplifier (Q8, Q9) whose outputs control the transmission factor of the voltage (U1) from the first electrode (A) to the second electrode (B) of the tuning capacitor (Ci).

7. Filter in accordance with claim 6, characterised in that, the outputs of the first differential amplifier (Q8, Q9) are connected to the bases of the two transistors (Q3, Q4) of a second differential amplifier and similarly to the bases of the two transistors (Q5, q6) of a third differential amplifier, that the first electrode of the tuning capacitor (Ci) is connected via an amplifying stage (Q1, Q2) to the interconnected emitters of the transistors (Q3, Q4) of the second differential amplifier, that the respective collectors of two transistors (Q3, Q5 or Q4, Q6) of the second and third differential amplifier are interconnected and one connecting point is connected to the operating voltage (VCC) and the other connecting point is connected to the input of an amplifying stage (Q7) and its output is connected to the second electrode (B) of the tuning capacitor (Ci) (Fig. 4).

8. Filter in accordance with claim 7, characterised in that, the amplifying stages (Q1, Q2, Q3) are constructed as emitter followers.

9. Filter in accordance with claim 3, characterised in that, there is a difference between the centre frequency of the resonant circuit (1) and the reference frequency (fref).

10. Filter in accordance with claim 3, characterised in that, a controllable amplifying stage (8) is located in the path of the control variable Us and its amplification level is switched between different amplification factors (1 or 0.99) between the forward sweep and the frame flyback by a vertical flyback pulse (V).

## Revendications

1. Filtre passe-bande pour signal à fréquence nominale avec circuit oscillant parallèle (1) auquel est connectée une capacité (Ci) contrôlée qui est le résultat de l'écart entre la fréquence de résonance et la variable réglante (Us) produisant la valeur nominale, **caractérisé en ce qu**'il est équipé d'un condensateur de réglage (Ci) dont la première électrode (A) est connectée au circuit oscillant (1), et dont la seconde électrode (B) est connectée à la source de tension (3) contrôlée par la variable réglante (Us) et à la tension stationnaire (U1) au circuit oscillant (1) et dont la tension stationnaire (U1) au circuit oscillant (1) et la constante de propagation (g) contrôlée par la variable réglante (Us) sont ainsi transmises à la seconde électrode (B).

2. Filtre conforme à la revendication 1, **caractérisé en ce que** la constante de propagation (g) est modifiable entre 0 et 2.

3. Filtre conforme à la revendication 1, **caractérisé en ce que** le filtre (1) est connecté en tant qu'élément de contrôle de la fréquence dans l'oscillateur (5) à des intervalles de temps récurrents et dont la tension de sortie et la tension de la fréquence de référence (fref) du filtre sont appliquées aux entrées de l'étage de comparaison de phase (4) qui fournit la variable réglante (Us).

4. Filtre conforme à la revendication 3, **caractérisé en ce que** l'intervalle de temps correspond au temps de retour vertical ou à une partie de ce temps.

5. Filtre conforme à la revendication 1, **caractérisé en ce qu**'un étage amplificateur (Q1 - Q7), contrôlé par la variable réglante (Us), est placé entre la première électrode (A) et la seconde électrode (B) du condensateur de réglage (Ci).

6. Filtre conforme à la revendication 5, **caractérisé en ce que** la variable réglante (Us) et la tension de référence (Vref) sont appliquées aux entrées d'un premier amplificateur-différenciateur (Q8, Q9), dont les sorties contrôlent la constante de propagation de la tension (U1) entre la première électrode (A) et la seconde électrode (B) du condensateur de réglage (Ci).

7. Filtre conforme à la revendication 6, **caractérisé en ce que** les sorties du premier amplificateur-différenciateur (Q8, Q9) sont connectées aux bases des deux transistors (Q3, Q4) d'un second amplificateur-différenciateur et aux bases des deux transistors (Q5, Q6) d'un troisième amplificateur-différenciateur et la première électrode du condensateur de réglage (Ci) est connectée aux émetteurs connectés entre-eux des transistors (Q3, Q4) du second amplificateur-différenciateur par l'intermédiaire d'un étage amplificateur (Q1, Q2), les collecteurs des deux transistors (Q3, Q4 et Q4, Q6) du second et du troisième amplificateur-différenciateur sont connectés entre-eux et un point de liaison à la tension de fonctionnement (VCC) ainsi qu'un autre point de liaison à l'entrée d'un étage amplificateur (Q7), dont la sortie est connectée à la seconde électrode (B) du condensateur de réglage (Ci), sont également mis en circuit.

8. Filtre conforme à la revendication 7, **caractérisé en ce que** les étages amplificateur (Q1, Q2, Q7) constituent l'émetteur-suiveur.

9. Filtre conforme à la revendication 3, **caractérisé en ce qu**'il existe une différence entre la fréquence moyenne du circuit oscillant (1) et la fréquence de référence (fref).

10. Filtre conforme à la revendication 3, **caractérisé en ce qu**'un étage amplificateur (8) contrôlable est placé sur la course de la variable réglante Us dont l'amplification peut être réglée sur plusieurs facteurs d'amplification (1 ou 0,99) grâce à une impulsion de retour vertical (V) entre l'aller et le retour de l'image.
